# EUROPEAN PATENT APPLICATION

(11) **EP 2 445 017 A2**
(43) Date of publication of application: **25.04.2012**
(21) Application number: 11180900.0
(22) Date of filing: 12.09.2011
(51) Int. Cl.: H01L 33/14, H01L 33/20

(54) **Vertical light-emitting semiconductor device**

(30) Priority: 19.10.2010 KR 20100101878
(71) Applicant: Samsung LED Co., Ltd., Gyunggi-do (KR)
(72) Inventor: Hong, Hyun-kwon, Chungcheongnam-do (KR); Lee, Sang-don, Gyeonggi-do (KR); Song, Kwang-min, Gwangju (KR); Lee, Kee-won, Seoul (KR)
(74) Representative: Grünecker, Kinkeldey, Stockmair & Schwanhäusser

(57) **Abstract**

A vertical light-emitting device includes: a substrate; a first electrode disposed on a bottom surface of the substrate; a reflection layer disposed on a top surface of the substrate; a current spreading layer disposed on the reflection layer and comprising a groove having a width narrower toward a top portion thereof; a light generation layer disposed on the current spreading layer; and a second electrode disposed on the light generation layer.

## Description

### BACKGROUND

### 1. Field

The present disclosure relates to light-emitting devices, more particularly to, vertical light-emitting devices.

### 2. Description of the Related Art

Light-emitting devices are one of solid devices that convert an electrical energy into light and emit the light, and are applied to illumination, liquid crystal display (LCD) backlight units, display apparatuses, etc. For example, light-emitting devices that emit visible light are used as light sources having a variety of uses, such as signal lights, automobile stop lights, view illumination lights, etc. Light-emitting devices necessarily improve light-emitting efficiency and reliability in order to expand their application ranges. In particular, vertical light-emitting devices need to improve light-emitting efficiency by increasing reflection efficiency.

### SUMMARY

Provided are vertical light-emitting devices capable of increasing reflection efficiency.

Additional aspects will be set forth in part in the description which follows and, in part, will be apparent from the description, or may be learned by practice of the presented embodiments.

According to an aspect of the present invention, a vertical light-emitting device includes: a substrate; a first electrode disposed on a bottom surface of the substrate; a reflection layer disposed on a top surface of the substrate; a current spreading layer disposed on the reflection layer and including a groove having a width narrower toward a top portion thereof; a light generation layer disposed on the current spreading layer; and a second electrode disposed on the light generation layer.

The groove may be formed in a bottom surface of the current spreading layer. The groove may be disposed in a bottom portion of the second electrode. The groove may be shaped corresponding to the second electrode.

The groove may be filled with air. The groove may be filled with a reflection material that reflects light generated from the light generation layer in a boundary surface between the current spreading layer and the groove.

The groove may have a triangular cross-section.

A top surface of the groove may have a uniform width. The top surface of the groove may have a planar shape. The top surface of the groove has a shape in such a way that the light generated from the light generation layer may be reflected to the outside the second electrode. The top surface of the groove may have a concave or convex shape.

The light generation layer may include: a first cladding layer formed on the current spreading layer, an active layer formed on the first cladding layer, and a second cladding layer formed on the active layer. The first cladding layer and the second cladding layer may be formed of p-type and n-type semiconductor materials, respectively, and the current spreading layer is formed of the p-type semiconductor material. The first electrode and the second electrode may be p-type and n-type electrodes, respectively. The substrate may be formed of a conductive material.

### BRIEF DESCRIPTION OF THE DRAWINGS

These and/or other aspects will become apparent and more readily appreciated from the following description of the embodiments, taken in conjunction with the accompanying drawings of which:

FIG. 1 is a cross-sectional view illustrating a vertical light-emitting device, according to an embodiment of the present invention;

FIG. 2 is a cross-sectional view illustrating a vertical light-emitting device, according to another embodiment of the present invention;

FIG. 3 is a cross-sectional view illustrating a vertical light-emitting device, according to another embodiment of the present invention;

FIG. 4 is a cross-sectional view illustrating a vertical light-emitting device, according to another embodiment of the present invention; and

FIG. 5 is a cross-sectional view illustrating a vertical light-emitting device, according to another embodiment of the present invention.

### DETAILED DESCRIPTION

Hereinafter, the present embodiments will be described more fully with reference to the accompanying drawings, in which exemplary embodiments of the invention are shown. The present embodiments may, however, be embodied in many different forms and should not be construed as limited to the exemplary embodiments set forth herein. Rather, these embodiments are provided so that this disclosure will be thorough and complete, and will fully convey the scope of the invention to those of ordinary skill in the art. In the drawings, the lengths and sizes of layers and regions may be exaggerated for clarity. Like numbers refer to like elements throughout. It will be understood that when a material layer substrate or layer is referred to as being "on" another material layer substrate or layer, the material layer substrate or layer may be directly on another substrate or layer or intervening substrates or layers. In addition, materials formed of each layer in the embodiments below are exemplary, and thus other materials may be used.

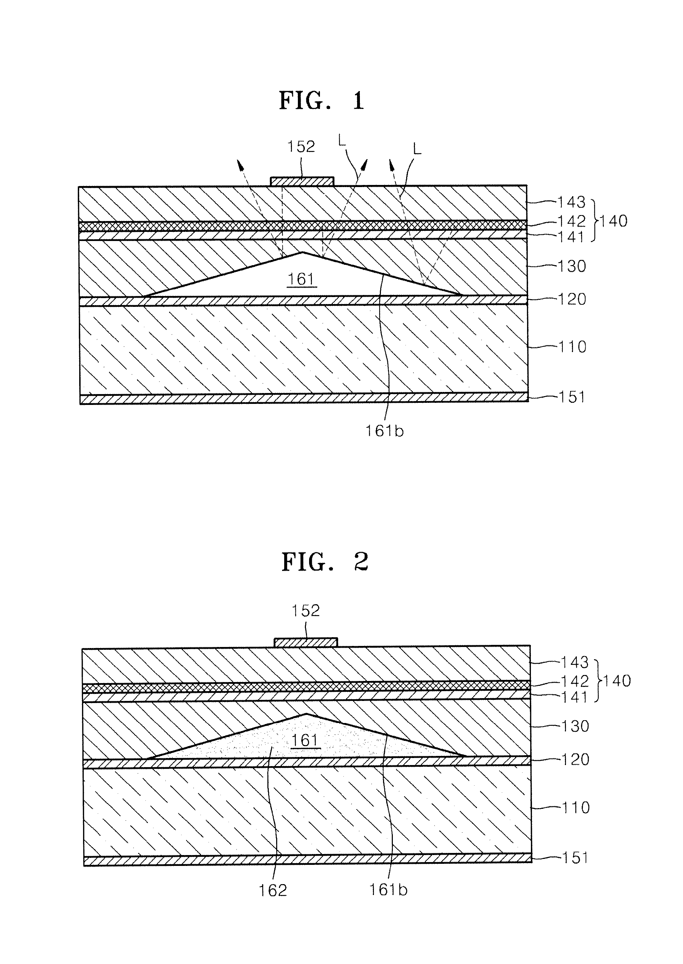

FIG. 1 a cross-sectional view illustrating a vertical light-emitting device, according to an embodiment of the present invention.

Referring to FIG. 1, the vertical light-emitting device of the present embodiment includes a substrate 110, a first electrode 151 disposed on a bottom surface of the substrate 110, a reflection layer 120 disposed on a top surface of the substrate 110, a current spreading layer 130 disposed on the reflection layer 120, a light generation layer 140 disposed on the current spreading layer 130, and a second electrode 152 disposed on the light generation layer 140. The light generation layer 140 may include a first cladding layer 141, an active layer 142, and a second cladding layer 143.

The substrate 110 may be formed of a conductive material. For example, a silicon substrate may be used as the substrate 110. However, the present embodiment is not limited thereto, and substrates formed of other various materials may be used as the substrate 110. The first electrode 151 is disposed on the bottom surface of the substrate 110. In this regard, the first electrode 151 may be a p-type electrode. The first electrode 151 may be formed to entirely cover the bottom surface of the substrate 110. The first electrode 151 may be formed of an excellent conductive material such as metal.

The reflection layer 120 is disposed on the top surface of the substrate 110. The reflection layer 120 reflects visible light L that is generated from the light generation layer 140 and moves to the substrate 110 toward the light generation layer 140. The reflection layer 120 may be formed of a metal material having an excellent reflection characteristic, and may be, for example, formed of Ag. However, the present embodiment is not limited thereto, and the reflection layer 120 may be formed of other various metal materials. The current spreading layer 130 is disposed on the reflection layer 120. The current spreading layer 130 uniformly injects current that flows from the first electrode 151 through the substrate 110 and the reflection layer 120 into the first cladding layer 141. The current spreading layer 130 may be formed of a p-type semiconductor material, and more particularly, a transparent p-type III-V group semiconductor compound through the visible light L transmits. For example, the current spreading layer 130 may be formed of p-GaP. However, the present embodiment is not limited thereto.

A groove 161 is formed in the bottom surface of the current spreading layer 130. A width of the groove 161 is reduced toward a top portion thereof, i.e. closer to the light generation layer 140. The groove 161 may have a triangular cross-section. The groove 161 is filled with air. Both side surfaces of the groove 161 may be inclination surfaces 161 b contacting the current spreading layer 130. In this regard, since the current spreading layer 130 is formed of a material having a greater refractive index than air, the visible light L that is generated from the light generation layer 140, more specifically, the active layer 142, and moves to the groove 161 is reflected from the inclination surfaces 161b of the groove 161 and moves forward the top portion of the light generation layer 140. Thus, reflection efficiency increases due to the groove 161, thereby improving light extraction efficiency. For example, the groove 161 may have a height between about 0.5 *µ*m and about 7 *µ*m, but the present embodiment is not limited thereto.

In the present embodiment, the groove 161 may be disposed in the bottom portion of the second electrode 152. In this case, a current spreading effect may increase, and reflection efficiency may be further improved. More specifically, the visible light L that is generated from the active layer 142 disposed in the bottom portion of the second electrode 152 and moves to the groove 161 is reflected from the inclination surfaces 161b of the groove 161 and exits to the second cladding layer 243 in the outside the second electrode 152 as shown in FIG. 1. Thus, light shading due to the second electrode 152 is reduced, which may further improve the reflection efficiency. Meanwhile, the groove 161 may have a shape corresponding to the second electrode 152 to increase a reflection area. For example, when the second electrode 152 is stripe-shaped, the groove 161 may be stripe-shaped corresponding to the second electrode 152.

The light generation layer 140 is disposed on the current spreading layer 130. the light generation layer 140 may include the first cladding layer 141 disposed on the top surface of the current spreading layer 130, the active layer 142 disposed on the top surface of the first cladding layer 141, and the second cladding layer 143 disposed on the top surface of the active layer 142. In this regard, the first and second cladding layers 141 and 143 may be formed of p-type and n-type III-V group semiconductor compounds, respectively. For example, the first and second cladding layers 141 and 143 may be formed of p-AllnP and n-AllnP/n-AlGalnP, respectively. However, the present embodiment is not limited thereto. The active layer 142 may have a multiple quantum well structure, and may be formed of a III-V group semiconductor compound. For example, the active layer 142 may be formed of GalnP.

The second electrode 152 is disposed on the second cladding layer 143. The second electrode 152 may be an n-type electrode. The second electrode 152 may be, for example, stripe-shaped on the second cladding layer 143. The second electrode 152 may be formed of an excellent conductive material such as metal.

As described above, in the present embodiment, the groove 161 is formed in the current spreading layer 130 disposed in the bottom portion of the light generation layer 140 and has the width narrower toward the light generation layer 140. Thus, the visible light L that is generated from the active layer 142 and moves to the groove 161 is reflected from the inclination surfaces 161b of the groove 161 and exits to the top portion of the light generation layer 140, thereby improving reflection efficiency. The groove 161 is disposed in the bottom portion of the second electrode 152, which increases the current spreading effect and further improves the reflection efficiency.

FIG. 2 is a cross-sectional view illustrating a vertical light-emitting device, according to another embodiment of the present invention. Referring to FIG. 2, the vertical light-emitting device of the present embodiment is the same as the vertical light-emitting device described with reference to FIG. 1, except that the groove 161 is filled with a reflection material 162. The differences therebetween will be described below.

Referring to FIG. 2, the groove 161 is formed in the bottom surface of the current spreading layer 130 disposed in the bottom portion of the light generation layer 140 and has a width narrower toward the light generation layer 140. In this regard, the groove 161 may have a triangular cross-section. The groove 161 is filled with the reflection material 162. The reflection material 162 is used to reflect the visible light L that is generated from the active layer 142 and moves to the groove 161 from the inclination surfaces 161b of the groove 161. To this end, the reflection material 162 may be formed of a material having a refractive index lower than the current spreading layer 130 or include a reflection coating layer (not shown) that reflects the visible light L.

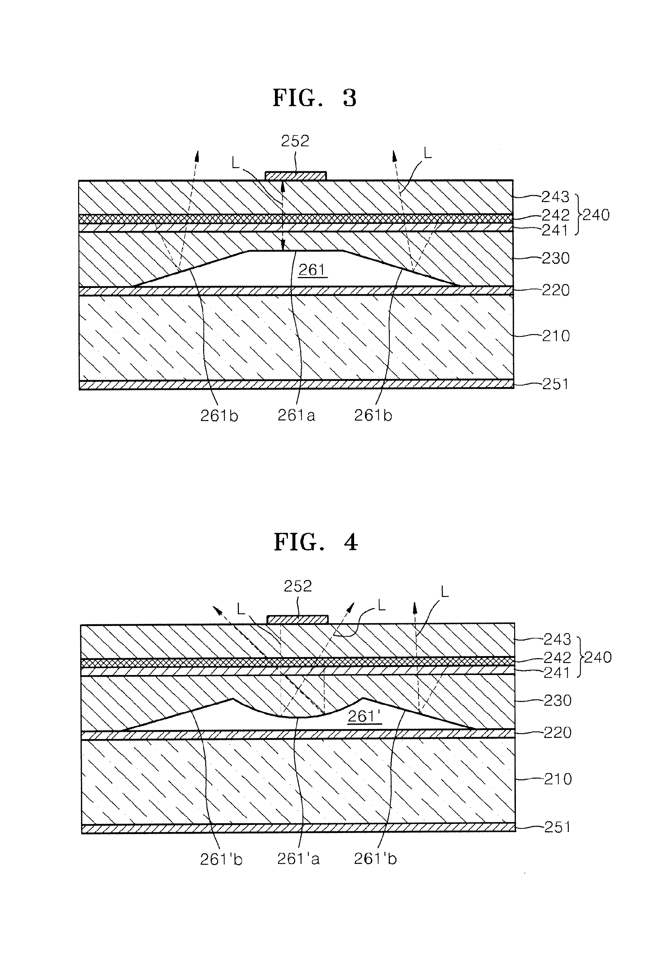

FIG. 3 is a cross-sectional view illustrating a vertical light-emitting device, according to another embodiment of the present invention. The differences between the previous embodiments and the present embodiment will be described below.

Referring to FIG. 3, the vertical light-emitting device of the present embodiment includes a substrate 210, a first electrode 251 disposed on a bottom surface of the substrate 210, a reflection layer 220 disposed on a top surface of the substrate 210, a current spreading layer 230 disposed on the reflection layer 220, a light generation layer 240 disposed on the current spreading layer 230, and a second electrode 252 disposed on the light generation layer 240. The light generation layer 240 may include a first cladding layer 241, an active layer 242, and a second cladding layer 243.

The substrate 210 may be formed of a conductive material. The first electrode 251 is disposed on the bottom surface of the substrate 210, and may be a p-type electrode. The reflection layer 220 is disposed on the top surface of the substrate 210, and may be formed of a metal material having an excellent reflection characteristic. The current spreading layer 230 may be formed of a p-type semiconductor material, and more particularly, a transparent p-type III-V group semiconductor compound through the visible light L transmits. For example, the current spreading layer 230 may be formed of p-GaP. However, the present embodiment is not limited thereto.

A groove 261 is formed in the bottom surface of the current spreading layer 230. A width of the groove 261 is reduced closer to the light generation layer 240. More specifically, the groove 261 may have a trapezoidal cross-section. That is, the groove 261 may include both side inclination surfaces 261b and a top surface 261a between the both side inclination surfaces 261b. In this regard, the top surface 261a of the groove 261 has a uniform width. The top surface 261a of the groove 261 may have a planar shape. The groove 261 is filled with air. Although not shown, the groove 261 may be filled with the reflection material 162 as shown in FIG. 2. The groove 261 may be disposed in the bottom portion of the second electrode 252, which may increase a current spreading effect, and reflection efficiency. For example, the groove 261 may have a shape corresponding to the second electrode 252 to increase a reflection area. For example, when the second electrode 252 is stripe-shaped, the groove 261 may be stripe-shaped corresponding to the second electrode 252.

The light generation layer 240 is disposed on the current spreading layer 230. the light generation layer 240 may include a first cladding layer 241 disposed on the top surface of the current spreading layer 330, an active layer 242 disposed on the top surface of the first cladding layer 241, and a second cladding layer 243 disposed on the top surface of the active layer 242. In this regard, the first and second cladding layers 241 and 243 may be formed of p-type and n-type III-V group semiconductor compounds, respectively. For example, the first and second cladding layers 241 and 243 may be formed of p-AllnP and n-AllnP/n-AlGalnP, respectively. However, the present embodiment is not limited thereto. The active layer 242 may have a multiple quantum well structure, and may be formed of a III-V group semiconductor compound. For example, the active layer 242 may be formed of GalnP. The second electrode 252 is disposed on the second cladding layer 243. The second electrode 252 may be an n-type electrode, and may be formed of an excellent conductive material such as metal.

In the vertical light-emitting device of the present embodiment, the visible light L that is generated from the active layer 242 and moves to the inclination surfaces 261 b of the groove 261 is reflected from the inclination surfaces 261 b of the groove 261 and exits to the top portion of the light generation layer 240. Meanwhile, the visible light L that is generated from the active layer 242 and moves to the top surface 261 a of the groove 261 does not exit to the outside the second electrode 252 due to the planarized top surface 261 a but comes and goes between the second electrode 252 and the top surface 261 a. Thus, light shading may occur due to the second electrode 252, and may be prevented in the embodiment described below.

FIG. 4 is a cross-sectional view illustrating a vertical light-emitting device, according to another embodiment of the present invention. The differences between the previous embodiments and the present embodiment will be described below.

Referring to FIG. 4, the first electrode 251 that is a p-type electrode is disposed on the bottom surface of the substrate 210, and the reflection layer 220 is disposed on the top surface of the substrate 210. The current spreading layer 230 formed of a p-type semiconductor material (for example, p-GaP) is disposed on the reflection layer 220. A groove 261' is formed in a bottom surface of the current spreading layer 230. The groove 261' has a width narrower toward the light generation layer 240. More specifically, groove 261' may include both side inclination surfaces 261'b and a top surface 261'a between the both side inclination surfaces 261'b. In this regard, the top surface 261'a of the groove 261' may have a uniform width, and have a concave shape. The groove 261' may be filled with air. Although not shown, the groove 261' may be filled with the reflection material 162 as shown in FIG. 2. The groove 261' may be disposed in the bottom portion of the second electrode 252, which may increase a current spreading effect, and further improve reflection efficiency. Further, the groove 261' may have a shape corresponding to the second electrode 252 to increase a reflection area.

The light generation layer 240 in which the first cladding layer 241, the active layer 242, and the second cladding layer 243 are sequentially stacked is disposed on the current spreading layer 230. In this regard, the first and second cladding layers 241 and 243 may be formed of p-type and n-type III-V group semiconductor compounds, respectively. The active layer 242 may be formed of a III-V group semiconductor compound. The second electrode 252 that is an n-type electrode is disposed on the second cladding layer 243.

In the vertical light-emitting device having the above structure, the top surface 261'a of the groove 261' has a concave shape. Thus, the visible light L that is generated from the active layer 242 and moves to the top surface 261'a of the groove 261' may be reflected from the concave top surface 261'a of the groove 261' and exit to the outside the second electrode 252 as shown in FIG. 4, and thus, light shading due to the second electrode 252 may be prevented. Meanwhile, the visible light L that is generated from the active layer 242 and moves to the inclination surfaces 261'b of the groove 261' is reflected from the inclination surfaces 261'b of the groove 261' and exits to the top portion of the light generation layer 240.

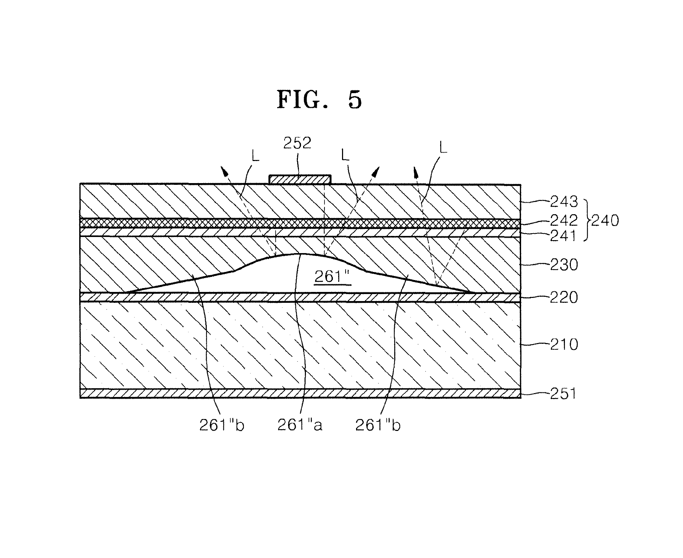

FIG. 5 is a cross-sectional view illustrating a vertical light-emitting device, according to another embodiment of the present invention. The differences between the previous embodiments and the present embodiment will be described below.

Referring to FIG. 5, the first electrode 251 that is a p-type electrode is disposed on the bottom surface of the substrate 210, and the reflection layer 220 is disposed on the top surface of the substrate 210. The current spreading layer 230 formed of a p-type semiconductor material (for example, p-GaP) is disposed on the reflection layer 220. A groove 261" is formed in a bottom surface of the current spreading layer 230. The groove 261" has a width narrower toward the light generation layer 240. More specifically, groove 261" may include both side inclination surfaces 261"b and a top surface 261"a between the both side inclination surfaces 261"b. In this regard, the top surface 261"a of the groove 261' may have a uniform width, and have a convex shape. The groove 261" may be filled with air. Although not shown, the groove 261" may be filled with the reflection material 162 as shown in FIG. 2. The groove 261" may be disposed in the bottom portion of the second electrode 252, which may increase a current spreading effect, and further improve reflection efficiency. Further, the groove 261" may have a shape corresponding to the second electrode 252 to increase a reflection area.

The light generation layer 240 in which the first cladding layer 241, the active layer 242, and the second cladding layer 243 are sequentially stacked is disposed on the current spreading layer 230. In this regard, the first and second cladding layers 241 and 243 may be formed of p-type and n-type III-V group semiconductor compounds, respectively. The active layer 242 may be formed of a III-V group semiconductor compound. The second electrode 252 that is an n-type electrode is disposed on the second cladding layer 243.

In the vertical light-emitting device having the above structure, the top surface 261"a of the groove 261" has a convex shape. Thus, the visible light L that is generated from the active layer 242 and moves to the top surface 261"a of the groove 261" may be reflected from the convex top surface 261"a of the groove 261" and exit to the outside the second electrode 252, and thus, light shading due to the second electrode 252 may be prevented. Meanwhile, the visible light L that is generated from the active layer 242 and moves to the inclination surfaces 261"b of the groove 261" is reflected from the inclination surfaces 261"b of the groove 261" and exits to the top portion of the light generation layer 240.

As described above, according to the one or more of the above embodiments of the present invention, a groove having a width narrower toward a light generation layer is formed in a p-type current spreading layer disposed in a bottom portion of the light generation layer, which may efficiently reflect visible light that is generated from an active layer and moves to the groove toward a top portion of the light generation layer by inclination surfaces of the groove. Further, the groove is formed in a bottom portion of an n-type electrode, so that light generated from the light generation layer is reflected from the inclination surfaces or a top surface of the groove and exits to the outside the n-type electrode, thereby further improving light extraction efficiency and increasing a current spreading effect.

It should be understood that the exemplary embodiments described therein should be considered in a descriptive sense only and not for purposes of limitation. Descriptions of features or aspects within each embodiment should typically be considered as available for other similar features or aspects in other embodiments.

## Claims

1. A vertical light-emitting device comprising:
a substrate;
a first electrode disposed on a bottom surface of the substrate;
a reflection layer disposed on a top surface of the substrate;
a current spreading layer disposed on the reflection layer and comprising a groove having a width narrower toward a top portion thereof;
a light generation layer disposed on the current spreading layer; and
a second electrode disposed on the light generation layer.

2. The vertical light-emitting device of claim 1, wherein the groove is formed in a bottom surface of the current spreading layer.

3. The vertical light-emitting device of claim 1, wherein the groove is disposed in a bottom portion of the second electrode.

4. The vertical light-emitting device of claim 1, wherein the groove is shaped corresponding to the second electrode.

5. The vertical light-emitting device of claim 1, wherein the groove is filled with air.

6. The vertical light-emitting device of claim 1, wherein the groove is filled with a reflection material that reflects light generated from the light generation layer in a boundary surface between the current spreading layer and the groove.

7. The vertical light-emitting device of claim 1, wherein the groove has a triangular cross-section.

8. The vertical light-emitting device of claim 1, wherein a top surface of the groove has a uniform width.

9. The vertical light-emitting device of claim 8, wherein the top surface of the groove has a planar shape.

10. The vertical light-emitting device of claim 8, wherein the top surface of the groove has a shape in such a way that the light generated from the light generation layer is reflected to the outside the second electrode.

11. The vertical light-emitting device of claim 10, wherein the top surface of the groove has a concave or convex shape.

12. The vertical light-emitting device of claim 1, wherein the light generation layer comprises: a first cladding layer formed on the current spreading layer, an active layer formed on the first cladding layer, and a second cladding layer formed on the active layer.

13. The vertical light-emitting device of claim 12, wherein the first cladding layer and the second cladding layer are formed of p-type and n-type semiconductor materials, respectively, and the current spreading layer is formed of the p-type semiconductor material.

14. The vertical light-emitting device of claim 13, wherein the first electrode and the second electrode are p-type and n-type electrodes, respectively.

15. The vertical light-emitting device of claim 1, wherein the substrate is formed of a conductive material.
